# EUROPEAN PATENT APPLICATION

(11) **EP 4 761 487 A1**
(43) Date of publication of application: **17.06.2026**
(21) Application number: 25222461.3
(22) Date of filing: 11.12.2025
(51) Int. Cl.: H05K 7/20

(54) **MODULAR COOLING AND PUMP LIQUID COOLING UNITS**

(30) Priority: 11.12.2024 US 202463730593 P; 04.12.2025 US 202519409512
(71) Applicant: Vertiv Corporation, Westerville, OH 43082 (US)
(72) Inventor: KING, JEREMY RYAN, Westerville, 43082 (US); SALEH, ADAM MUSTAFA, Westerville, 43082 (US); MADARA, STEVEN MITCHELL, Westerville, 43082 (US)
(74) Representative: Cousens, Nico

(57) **Abstract**

A cooling system can extract heat from one or more heat sources disposed in one or more rows of cabinets with a cold aisle on one side of the row of cabinets, a hot aisle on another side of the row of cabinets, and a containment plenum above the hot aisle. The cooling system can include one or more cooling modules for transferring heat from a fluid to air passing through the cooling module and a pumping module for inducing flow of the fluid between the cooling module and the heat sources. One or more modules can be aligned with the cabinets in the row of cabinets. One or more modules can be disposed at least partially in or across the hot aisle.

## Description

This application claims the benefit of U.S. Provisional Patent Application No. 63/730,593 filed December 11, 2024.

### TECHNICAL FIELD

The present disclosure relates generally to cooling systems, such as for use in data centers, and more specifically relates to conversion of air-cooled data centers into high-density, liquid-cooled data centers.

### BACKGROUND

As liquid-cooled IT racks for Al workloads are deployed, data centers are looking to retrofit existing air-cooled data centers with new technology. In most cases, current air-cooled data centers have very little flexibility to deploy a liquid-cooled infrastructure (e.g., insufficient roof space, insufficient yard space). These limitations can drive data center operators to make changes within the white space.

### SUMMARY

The Applicant has created new and useful devices, systems and methods for conversion of air-cooled data centers into high-density, liquid-cooled data centers, which can provide for substantially increased cooling capacity within an existing white space of a given size. In at least one embodiment, a cooling system according to the disclosure can include multiple cooling modules coupled with a pumping module and designed and constructed to enable the rapid conversion of a traditional air-cooled data center to a high-density, liquid-cooled data center with minimal changes to existing infrastructure. In at least one embodiment, a cooling system according to the disclosure can replace existing Information Technology (IT) racks or cabinets with minimal or no changes to the hot aisle containment or overhead equipment. In at least one embodiment, one or more cooling modules and/or one or more pumping modules can be disposed across the hot aisle, can be disposed above the hot aisle, can straddle the hot aisle, can be partially disposed in the hot aisle, or any combination thereof.

In at least one embodiment, a cooling system according to the disclosure can extract heat from one or more heat sources disposed in one or more rows of cabinets with a cold aisle on one side of the row of cabinets, a hot aisle on another side of the row of cabinets, and a containment plenum above the hot aisle. In at least one embodiment, the cooling system can include one or more cooling modules for transferring heat from a fluid to air passing through the cooling module, a pumping module for inducing flow of the fluid between the cooling module and the heat sources, a controller for controlling the cooling module and/or the pumping module, such as based at least in part on a differential pressure and/or a temperature of the fluid, or any combination thereof. In at least one embodiment, the pumping module can include one or more pumps. In at least one embodiment, the cooling module and/or the pumping module can be aligned with the cabinets in the row of cabinets. In at least one embodiment, the cooling module and/or the pumping module can be disposed at least partially in the hot aisle.

In at least one embodiment, the cooling module can be or include an in-row chiller for rejecting heat to the hot aisle. In at least one embodiment, the cooling module can receive air from the cold aisle and exhaust air to the hot aisle. In at least one embodiment, the cooling module can route or exhaust air to the hot aisle and/or the containment plenum. In at least one embodiment, the cooling module can include one or more fans and one or more fluid-to-air heat exchangers. In at least one embodiment, the cooling module can include one or more condensers. In at least one embodiment, the fan can move air from the cold aisle through the fluid-to-air heat exchanger and into the hot aisle. In at least one embodiment, the system can include a plurality of fans, such as a first fan disposed above a second fan. In at least one embodiment, the fluid-to-air heat exchanger can include a face, which can be disposed vertically.

In at least one embodiment, the cooling module can be serviced from a front side of the cooling module and a rear side of the cooling module. In at least one embodiment, the cooling module can be serviced from the front side and the rear side while the cooling module is disposed at least partially in the hot aisle. In at least one embodiment, the front side can face one of the hot aisle and the cold aisle, and the rear side can face the other one of the hot aisle and the cold aisle. In at least one embodiment, the cooling module can be selectively coupled to and uncoupled from one or more fluid manifolds that can route the fluid among the cooling module(s), the pumping module, the cabinets in the row of cabinets, or any combination thereof.

In at least one embodiment, a first cooling module and a second cooling module can each have a front side for facing the cold aisle and a rear side for facing the hot aisle. In at least one embodiment, the first cooling module and the second cooling module can be disposed across from one another with at least a portion of the hot aisle disposed between the rear side of the first cooling module and the rear side of the second cooling module.

In at least one embodiment, the cooling module and/or the pumping module can be disposed across the hot aisle and/or can straddle the hot aisle. In at least one embodiment, the cooling module and/or the pumping module can be disposed at least partially in the hot aisle, at an end of the row of cabinets, at least partially between a first row of cabinets and a second row of cabinets that is parallel to the first row of cabinets, or any combination thereof. In at least one embodiment, the system can include a plurality of cooling modules, which can be plumbed in parallel, can be interchangeable, can be disposed side-by-side, can be disposed across the cold aisle from one another and/or can be disposed across the hot aisle from one another, or any combination thereof. In at least one embodiment, the pumping module can be disposed side-by-side with one or more of the cooling modules. In at least one embodiment, the pumping module can be disposed between the cooling module and the cabinets.

In at least one embodiment, any or all of the cooling modules can include a free cooling loop or circuit and/or a Direct Expansion (DX) cooling loop or circuit, any or all of which can be plumbed in parallel or series. In at least one embodiment, the fluid-to-air heat exchanger can be or include a free-cooling heat exchanger, which can be plumbed in fluid communication with the pumping module. In at least one embodiment, the fluid-to-air heat exchanger can be or include a condenser. In at least one embodiment, the DX cooling circuit can include a compressor. In at least one embodiment, the fluid-to-air heat exchanger can include a first free-cooling heat exchanger disposed adjacent to a first condenser and a second free-cooling heat exchanger disposed adjacent to a second condenser. In at least one embodiment, the cooling module can have an air flow path from an air inlet to an air outlet. In at least one embodiment, the free-cooling heat exchanger and/or the condenser can be disposed in the air flow path. In at least one embodiment, the condenser can be disposed downstream of the free-cooling heat exchanger.

In at least one embodiment, the cooling module can have a cooling module housing. In at least one embodiment, the free-cooling heat exchanger, the condenser, the compressor, or any combination thereof can be disposed within the cooling module housing. In at least one embodiment, the fan can be disposed downstream of the condenser and/or route exhaust air upwardly and out of a top of the cooling module housing. In at least one embodiment, the cooling module can include a fluid-to-fluid heat exchanger disposed within the cooling module housing. In at least one embodiment, the fluid-to-fluid heat exchanger can have a DX flow path in fluid communication with the DX cooling circuit and a free-cooling flow path in fluid communication with the free-cooling heat exchanger. In at least one embodiment, the free-cooling flow path of the fluid-to-fluid heat exchanger can be fluidically downstream of the free-cooling heat exchanger.

In at least one embodiment, the cooling module and/or the pumping module can retrofit an existing data center. In at least one embodiment, the cooling module and/or the pumping module can be installed in place of one or more of the cabinets in the row of cabinets. In at least one embodiment, the cooling module and/or the pumping module can at least partially convert one or more of the cabinets in the row of cabinets from air-cooled to liquid-cooled. In at least one embodiment, the cooling module can have a cooling module depth and at least one of the cabinets can have a cabinet depth. In at least one embodiment, the cooling module depth can be less than or equal to the cabinet depth.

In at least one embodiment, a method according to the disclosure can be used for retrofitting a data center having heat sources disposed in a row of cabinets with a cold aisle on one side of the row of cabinets, a hot aisle on another side of the row of cabinets, and a containment plenum above the hot aisle. In at least one embodiment, the method can include aligning at least one cooling module with the cabinets in the row, aligning a pumping module with the cabinets in the row, converting the row of cabinets from air-cooled cabinets to liquid-cooled cabinets, or any combination thereof. In at least one embodiment, any or all of the cooling modules can transfer heat from a fluid to air passing through the cooling module and/or can include one or more fans and one or more fluid-to-air heat exchanger. In at least one embodiment, the pumping module can induce flow of the fluid between the cooling module and the heat sources and/or can include one or more pumps.

### BRIEF DESCRIPTION OF THE DRAWINGS

FIG. 1 is a simplified diagram of one of many embodiments of a cooling system according to the disclosure.
FIG. 2 is a semi-transparent perspective view of one of many embodiments of a cooling module according to the disclosure.
FIG. 3 is a plan view of one of many embodiments of a cooling system according to the disclosure.
FIG. 4 is a plan view of another one of many embodiments of a cooling system according to the disclosure.
FIG. 5 is a plan view of yet another one of many embodiments of a cooling system according to the disclosure.
FIG. 6 is a semi-transparent elevation view of one of many embodiments of a cooling module according to the disclosure.
FIG. 7 is a simplified diagram depicting removal of fans from one of many embodiments of a cooling module according to the disclosure.
FIG. 8 is a semi-transparent perspective view of one of many embodiments of a cooling system according to the disclosure, showing one of many embodiments of a cooling module and one of many embodiments of a pumping module installed under a hot aisle containment plenum.
FIG. 9 is a simplified diagram of one of many embodiments of a cooling module according to the disclosure.
FIG. 10 is a semi-transparent perspective view of another one of many embodiments of a cooling system according to the disclosure.
FIG. 11 is a semi-transparent perspective view of another one of many embodiments of a cooling module according to the disclosure.
FIG. 12 is a semi-transparent elevation view of another one of many embodiments of a cooling module according to the disclosure.
FIG. 13 is a semi-transparent perspective view of the cooling module of FIG. 12.
FIG. 14 is a semi-transparent perspective view of yet another one of many embodiments of a cooling system according to the disclosure.
FIG. 15 is a semi-transparent elevation view of still another one of many embodiments of a cooling system according to the disclosure.
FIG. 16 is a semi-transparent perspective view of the cooling system of FIG. 15.

### DETAILED DESCRIPTION

The figures described above and the written description of specific structures and functions below are not presented to limit the scope of what the Applicant has disclosed or the scope of the appended claims. Rather, the figures and written description are provided to teach any person skilled in the art to make and use the disclosures for which patent protection is sought. Those skilled in the art will appreciate that not all features of a commercial embodiment of the disclosures are described or shown for the sake of clarity and understanding. Persons of skill in this art will also appreciate that the development of an actual commercial embodiment incorporating aspects of the present disclosures will require numerous implementation-specific decisions to achieve the developer's ultimate goal for the commercial embodiment. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the discosures or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems, methods, and computer program products according to various embodiments of the present disclosure. In this regard, each block in a flowchart may represent a module, segment, or portion of code, which can comprise one or more executable instructions for implementing the specified logical function(s). It should also be noted that, in some implementations, the function(s) noted in the block(s) might occur out of the order depicted in the figures. For example, blocks shown in succession may, in fact, be executed substantially concurrently. It will also be noted that each block of a flowchart illustration can be implemented by special purpose hardware-based systems that perform the specified functions or acts, or combinations of special purpose hardware and computer instructions.

The Applicant has created new and useful devices, systems and methods for conversion of air-cooled data centers into high-density, liquid-cooled data centers, which can provide for substantially increased cooling capacity within an existing white space of a given size. In at least one embodiment, a cooling system according to the disclosure can include multiple cooling modules coupled with a pumping module and designed and constructed to enable the rapid conversion of a traditional air-cooled data center to a high-density, liquid-cooled data center with minimal changes to existing infrastructure. In at least one embodiment, a cooling system according to the disclosure can replace existing Information Technology (IT) racks or cabinets without requiring changes to the hot aisle containment or overhead equipment. In at least one embodiment, the cooling module and/or the pumping module can be disposed across the hot aisle, be disposed above the hot aisle, can straddle the hot aisle, be partially disposed in the hot aisle, or any combination thereof.

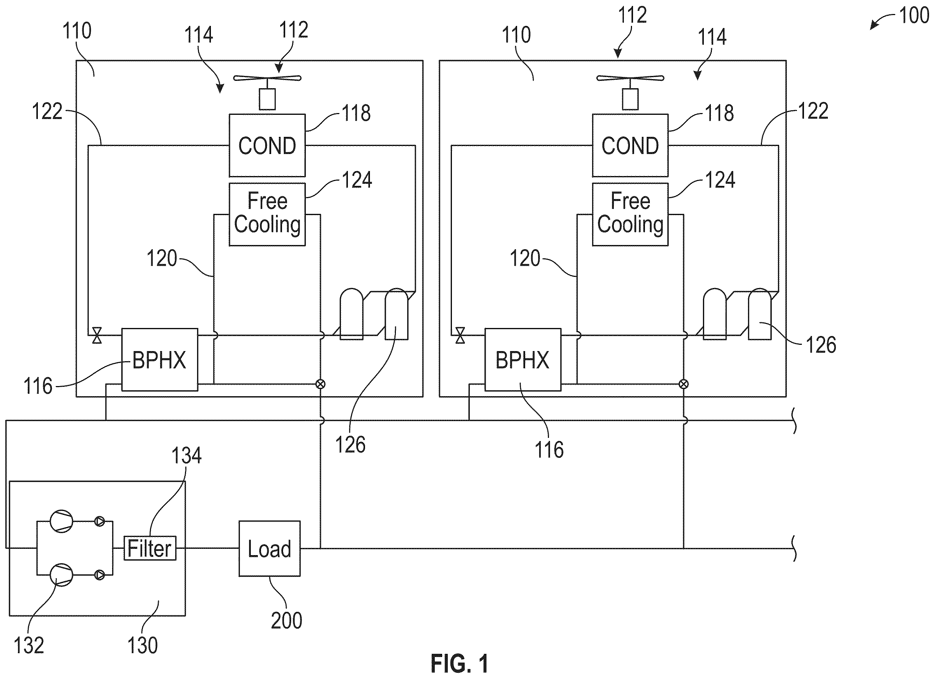

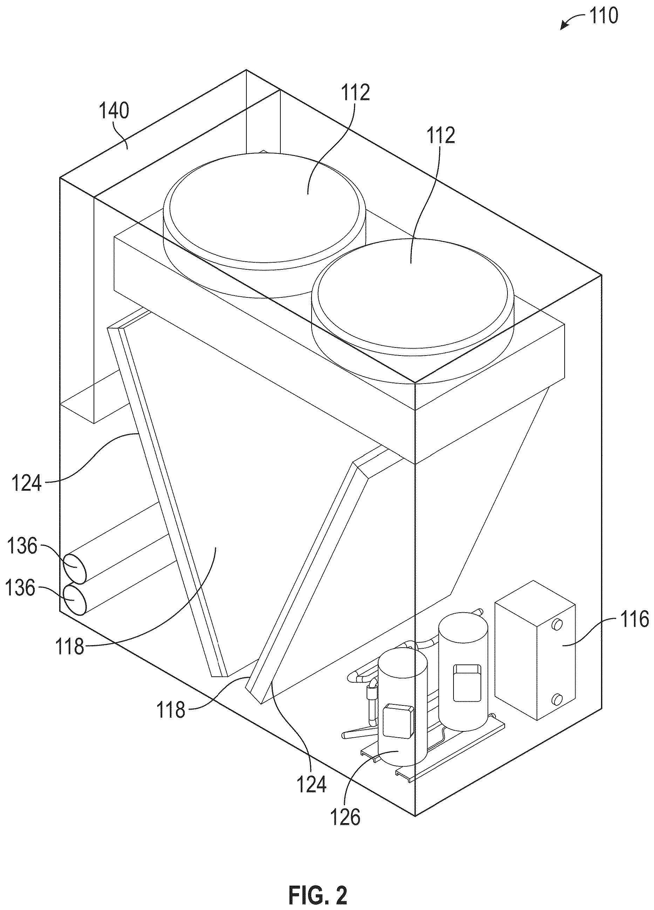

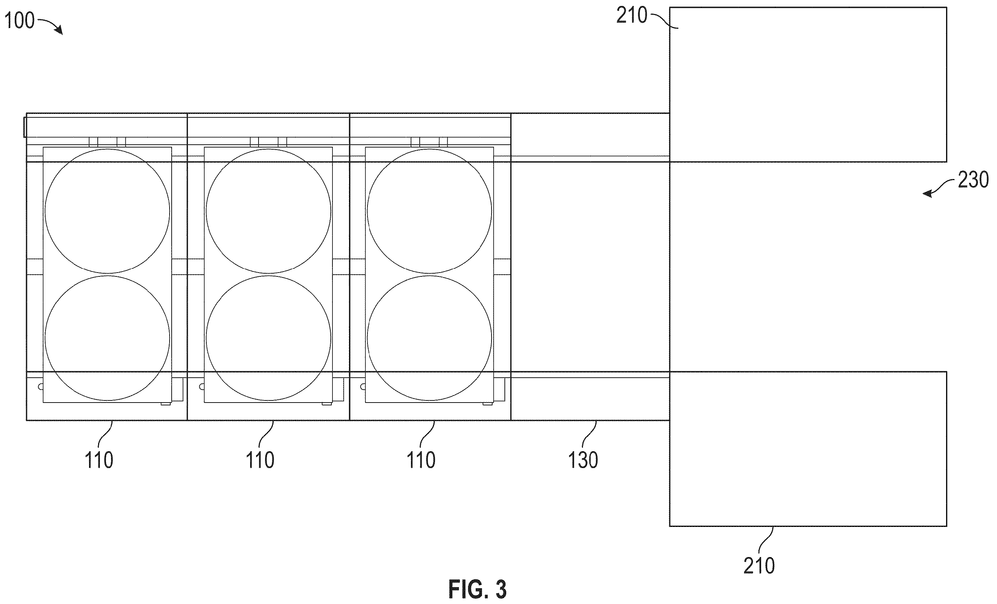

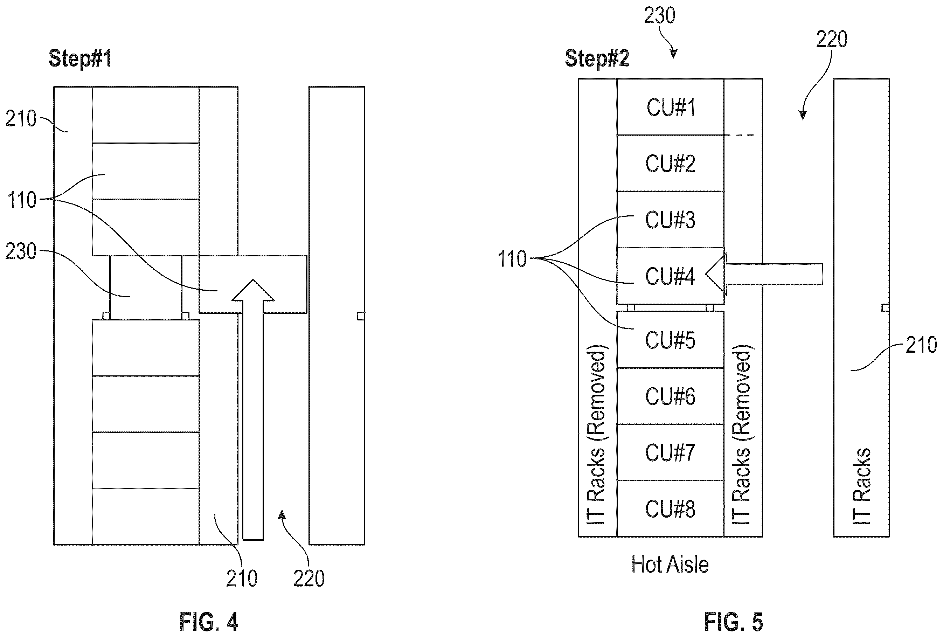

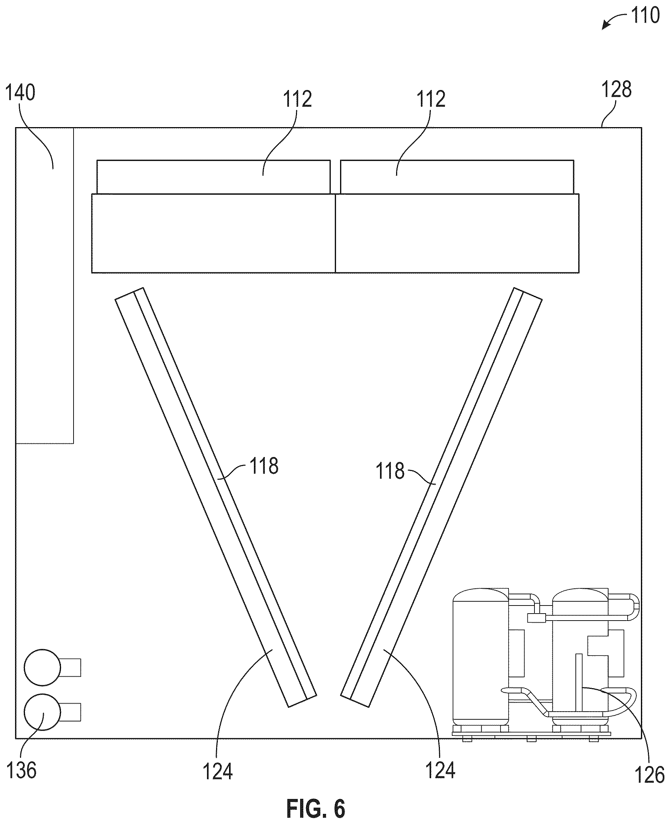

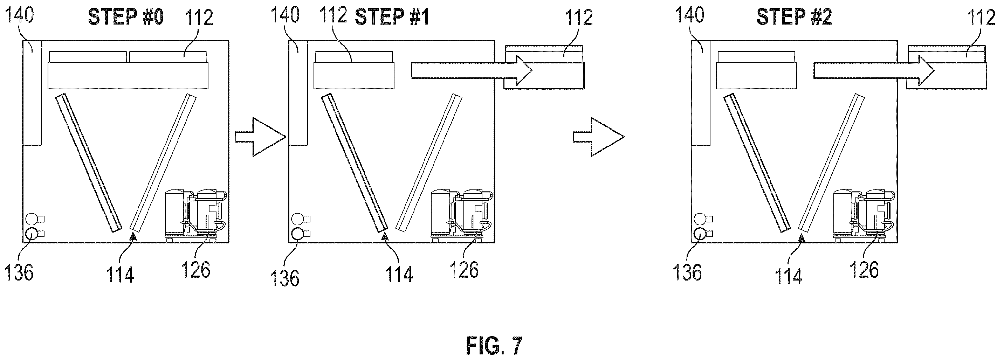

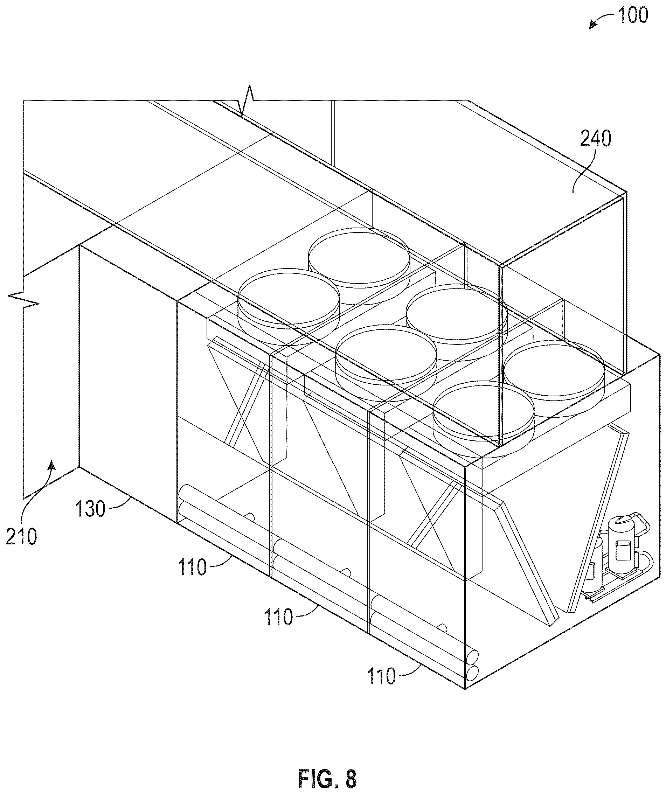

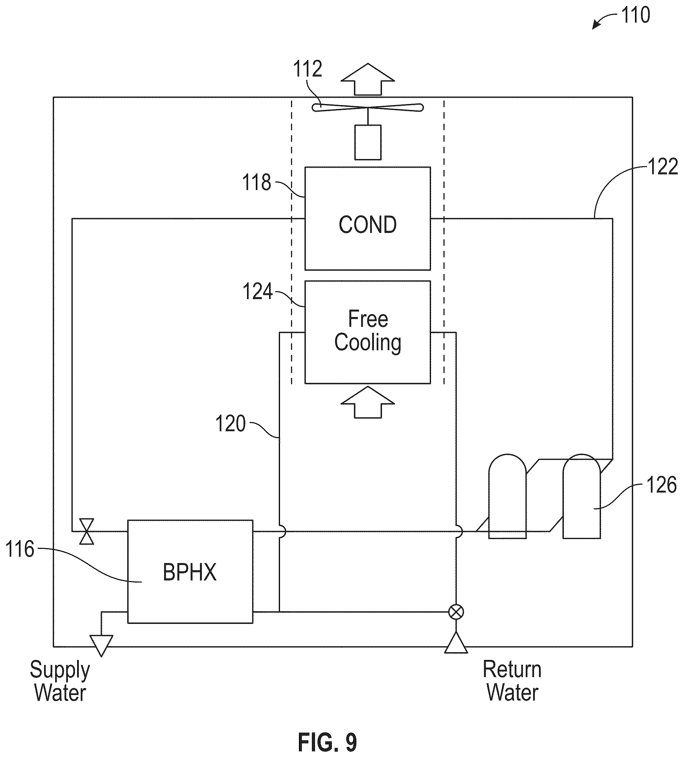

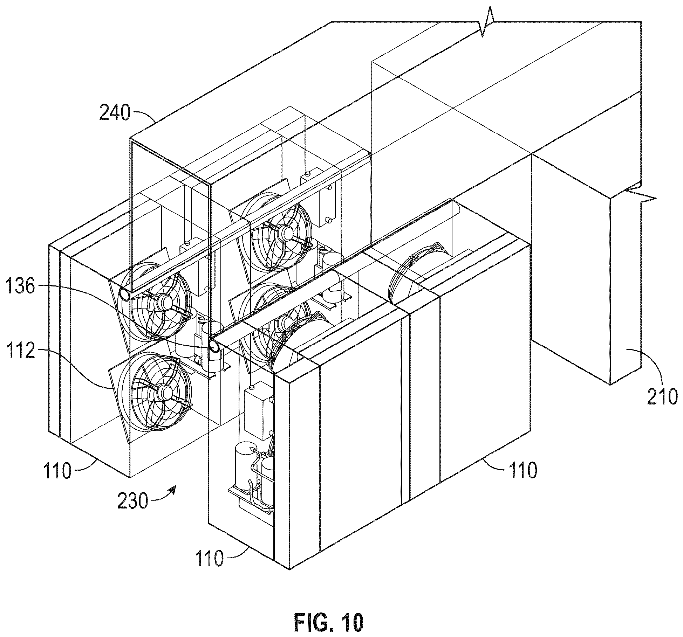

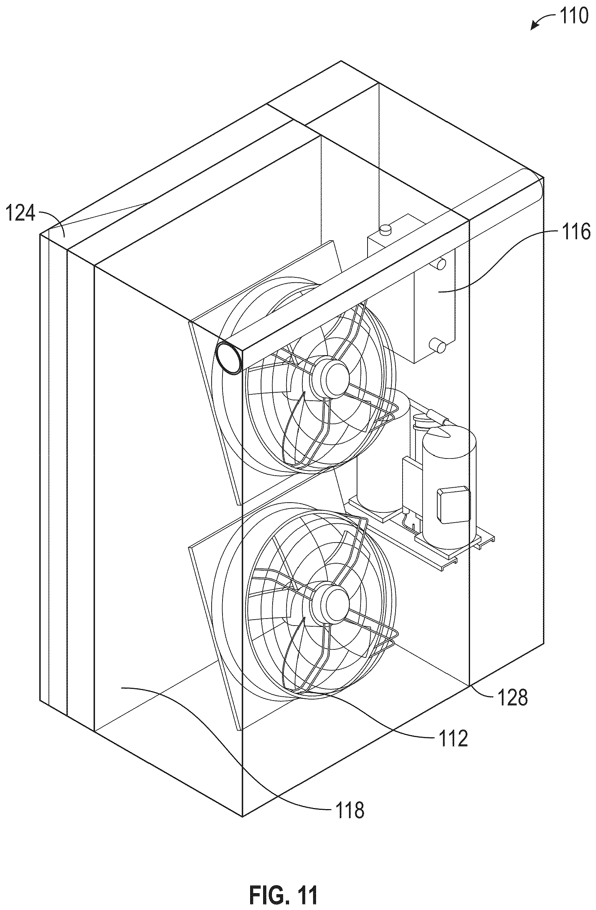

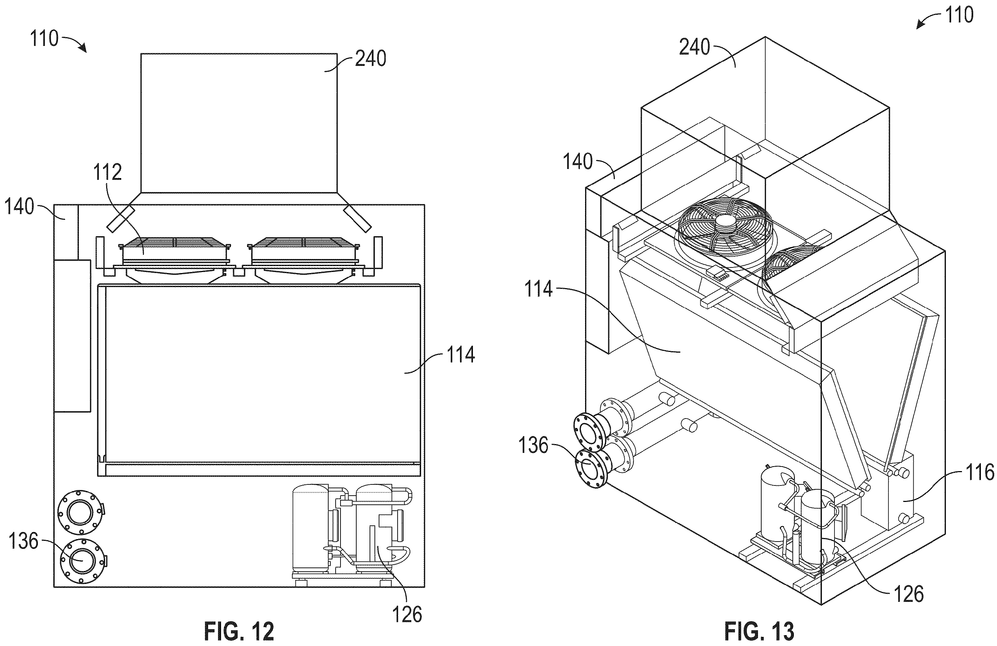

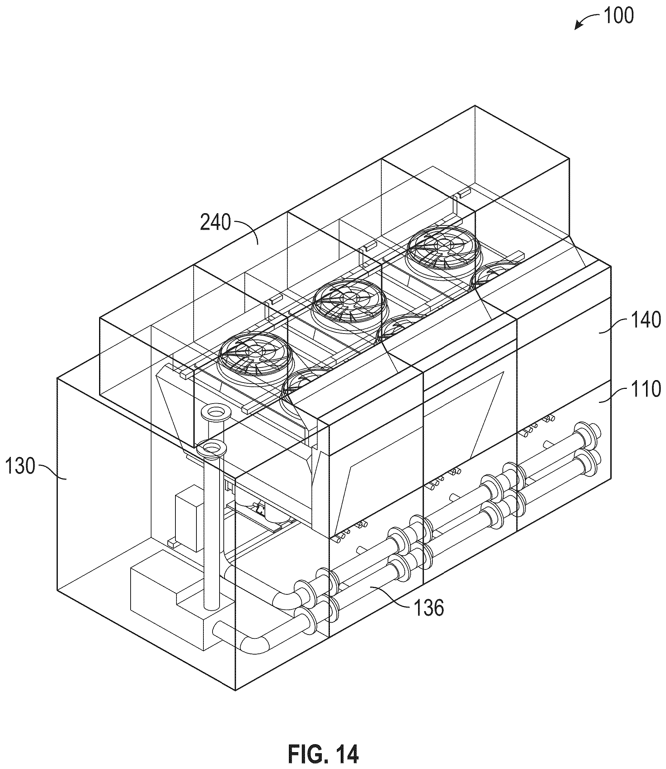

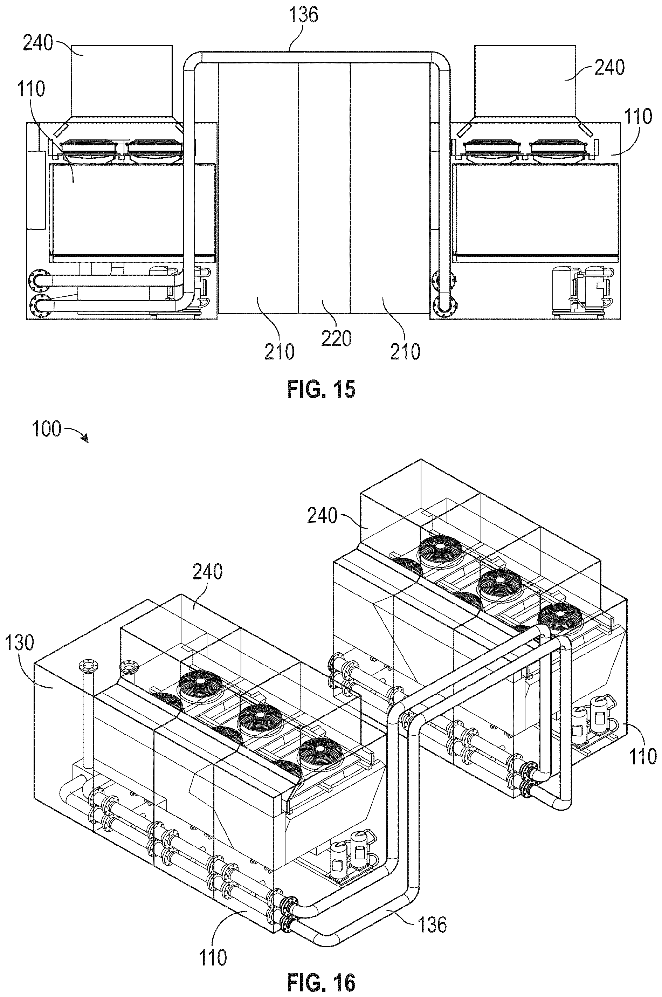

FIG. 1 is a simplified diagram of one of many embodiments of a cooling system according to the disclosure. FIG. 2 is a semi-transparent perspective view of one of many embodiments of a cooling module according to the disclosure. FIG. 3 is a plan view of one of many embodiments of a cooling system according to the disclosure. FIG. 4 is a plan view of another one of many embodiments of a cooling system according to the disclosure. FIG. 5 is a plan view of yet another one of many embodiments of a cooling system according to the disclosure. FIG. 6 is a semi-transparent elevation view of one of many embodiments of a cooling module according to the disclosure. FIG. 7 is a simplified diagram depicting removal of fans from one of many embodiments of a cooling module according to the disclosure. FIG. 8 is a semi-transparent perspective view of one of many embodiments of a cooling system according to the disclosure, showing one of many embodiments of a cooling module and one of many embodiments of a pumping module installed under a hot aisle containment plenum. FIG. 9 is a simplified diagram of one of many embodiments of a cooling module according to the disclosure. FIG. 10 is a semi-transparent perspective view of another one of many embodiments of a cooling system according to the disclosure. FIG. 11 is a semi-transparent perspective view of another one of many embodiments of a cooling module according to the disclosure. FIG. 12 is a semi-transparent elevation view of another one of many embodiments of a cooling module according to the disclosure. FIG. 13 is a semi-transparent perspective view of the cooling module of FIG. 12. FIG. 14 is a semi-transparent perspective view of yet another one of many embodiments of a cooling system according to the disclosure. FIG. 15 is a semi-transparent elevation view of still another one of many embodiments of a cooling system according to the disclosure. FIG. 16 is a semi-transparent perspective view of the cooling system of FIG. 15. FIGS. 1-16 are described in conjunction with one another.

In at least one embodiment, a cooling system 100 according to the disclosure can extract heat from one or more heat sources 200, such as servers and/or other Information Technology (IT) equipment disposed in one or more rows of one or more IT racks or cabinets 210. In at least one embodiment, a row of IT cabinets 210 can have a cold aisle 220 on one side of the row of cabinets 210, a hot aisle 230 on another side of the row of cabinets 210, and a containment plenum 240 above the hot aisle 230. In at least one embodiment, the cooling system 100 can include one or more cooling modules 110 for transferring heat from a fluid to air passing through the cooling module 110, a pumping module 130 for inducing flow of the fluid between the cooling module 110 and the heat sources 200, a controller 140 for controlling the cooling module 110 and/or the pumping module 130, such as based at least in part on a differential pressure and/or a temperature, or any combination thereof. In at least one embodiment, the cooling module 110 and/or the pumping module 130 can be aligned with the cabinets 210 in the row of cabinets. In at least one embodiment, the cooling module(s) 110 and/or the pumping module 130 can be disposed at least partially in the hot aisle 230, at least partially above the hot aisle 230, at least partially across the hot aisle 230, or any combination thereof. In at least one embodiment, the cooling module(s) 110 and/or the pumping module 130 can be installed down a full length of the hot aisle 230, which can allow more cooling modules 110 to be headered together with less impact to white space, such as within a data center.

In at least one embodiment, the pumping module 130 can move the fluid through and between the cooling modules 110 and the cabinets 210. In at least one embodiment, the pumping module 130 can include one or more pumps 132 and/or one or more fluid filtration assemblies 134. In at least one embodiment, the pumping module 130 can include redundant pumps, one or more expansion tanks, one or more air separators, one or more buffer tanks, one or more uninterruptable power supplies (UPS(s)), other equipment, or any combination thereof. In at least one embodiment, the pump(s) 132 in the pumping module 130 can control to a differential pressure between an inlet of a first cooling module 110 and an outlet of the pumping module 130. In at least one embodiment, pump power can increase and/or be increased for each additional cooling module 110 headered together. In at least one embodiment, the system 100 can include one or more UPSs for providing power to one or more pumps 132, one or more fans 112, one or more compressors 126, one or more other system components, or any combination thereof.

In at least one embodiment, the cooling module 110 can be or include an in-row chiller, and/or another in-row heat exchanger, such as a free-cooling (non-vapor compression) heat exchanger, for rejecting heat to the hot aisle 230. In at least one embodiment, the system 100 can include a plurality of cooling modules 110, two or more of which can be interchangeable or modular. In at least one embodiment, the system 100 can include a plurality of cooling modules 110 plumbed in parallel, a plurality of cooling modules 110 plumbed in series, or both. For example, in at least one embodiment, the system 100 can include two or more groups or sets of cooling modules 110 that each include two or more cooling modules 110 plumbed in series, and two or more of the groups of cooling modules 110 can be plumbed in parallel. As another example, in at least one embodiment, the system 100 can include two or more cooling modules 110 plumbed in series, and two or more other cooling modules 110 plumbed in parallel.

In at least one embodiment, one or more cooling modules 110 can be selectively coupled to and uncoupled from one or more fluid manifolds 136, such as for routing the fluid between or among the cooling module(s) 110, the pumping module 130, the cabinets 210 in the row of cabinets, or any combination thereof. In at least one embodiment, the cooling module 110 and/or the pumping module 130 can be disconnected from the manifold 136, leaving the manifold 136 in place, such as for repair to be performed at a different location. In at least one embodiment, one or more cooling modules 110 and/or one or more pumping modules 130 can be comprised of two or more portions arranged for readily being coupled and/or uncoupled from one another, such as for easing installation and/or removal of a module into and/or from a location having limited space. For example, in at least one embodiment, one or more of the modules 110, 130 can include a frame or other support structure adapted for being installed and/or removed in two or more sections or other subunits.

In at least one embodiment, the cooling module 110 can route or exhaust air to the hot aisle 230 and/or the containment plenum 240. In at least one embodiment, the cooling module 110 can receive air from the cold aisle 220 and exhaust air to the hot aisle 230 and/or the containment plenum 240. In at least one embodiment, the cooling module 110 can include one or more fans 112, one or more fluid-to-air heat exchangers 114, one or more fluid-to-fluid heat exchangers 116, one or more free cooling heat exchangers, one or more condensers 118, or any combination thereof. In at least one embodiment, the fan 112 can move air from the cold aisle 220 through the fluid-to-air heat exchanger 114 and into the hot aisle 230. In at least one embodiment, the system 100 can include a plurality of fans 112, such as a first fan disposed above a second fan. In at least one embodiment, one or more fans 112 can be disposed at an angle (e.g., relative to horizontal) for moving air into and/or out of one or more airflow paths through the cooling module 110 more efficiently than a conventional cooling unit, such as, for example, by more efficiently funneling or otherwise routing airflow into an existing plenum 240 or other hot aisle 230 infrastructure. In at least one embodiment, any or all of the heat exchangers 114, 116, 118 can include a face, which can be disposed vertically. In at least one embodiment, the cooling module 110 can be arranged for use within a raised floor implementation and, for example, air can enter the cooling module 110 from underneath and/or from one or more cold aisles 220.

Standard data center cabinet dimensions typically include a height of 42U, which is about 73.5 inches (1866.90 mm), with each U equaling 1.75 inches (44.45 mm), a width of 19 inches (483 mm) for mounting equipment, and varying depths, commonly around 24 to 30 inches. In at least one embodiment, the cooling module 110 and/or the pumping module 130 can have a module depth and at least one of the cabinets 210 can have a cabinet depth. In at least one embodiment, the module depth can be less than or equal to the cabinet depth. In at least one embodiment, any or all of the cabinets 210 can have a cabinet footprint of standardized width and/or depth dimensions. In at least one embodiment, the cooling module 110 and/or the pumping module 130 can have a module footprint that is an integer multiple of the cabinet footprint. For example, the cooling module 110 and/or the pumping module 130 can be the cabinet depth, such as between 24 and 30 inches, and/or two or three times the cabinet footprint, such as 38 or 57 inches wide.

In at least one embodiment, the cooling module 110 can be arranged for being serviced from a front side of the cooling module 110 and a rear side of the cooling module 110. In at least one embodiment, some or all components of the cooling module 110 and/or some or all components of the pumping module 130 can be serviceable from the front and/or the rear, while the cooling module 110 and/or the pumping module 130 is installed, such as in the row of cabinets 210 and/or in the hot aisle 230. In at least one embodiment, the cooling module 110 can be serviced from the front side and the rear side while the cooling module 110 is disposed at least partially in the hot aisle 230. In at least one embodiment, the front side can face one of the hot aisle 230 and the cold aisle 220, and the rear side can face the other one of the hot aisle 230 and the cold aisle 220. For example, the front side can face the hot aisle 230 and the rear side can face the cold aisle 220, or the front side can face the cold aisle 220 and the rear side can face the hot aisle 230. In at least one embodiment, the fan(s) 112 can be selectively removed from the front side and/or the rear side, such as while any or all of the heat exchangers 114, 116, 118 remain in place, as illustrated in FIG. 7, for example.

In at least one embodiment, the system 100 can include a plurality of cooling modules 110 disposed side-by-side and/or across from one another. In at least one embodiment, a first cooling module 110 and a second cooling module 110 can each have a front side for facing the cold aisle 220 and a rear side for facing the hot aisle 230. In at least one embodiment, the first cooling module 110 and the second cooling module 110 can be disposed across from one another with at least a portion of the hot aisle 230 disposed between the rear side of the first cooling module 110 and the rear side of the second cooling module 110. In at least one embodiment, the pumping module 130 can be disposed side-by-side with one or more of the cooling modules 110.

In at least one embodiment, any or all of a cooling module 110 and/or any or all of a pumping module 120 can be disposed across the hot aisle 230, can be disposed above the hot aisle 230, can straddle the hot aisle 230, or any combination thereof. In at least one embodiment, any or all of a cooling module 110 and/or any or all of a pumping module 120 can be disposed above the hot aisle 230 and/or can straddle the hot aisle 230, which can include trimming a portion of the containment plenum 240 (i.e., as required or desired in accordance with an implementation of the disclosure). In at least one embodiment, the front side of a cooling module 110 can be disposed above a first row of cabinets 210 and the rear side of a cooling module 110 can be disposed above a second row of cabinets 210, such as illustrated in FIG. 4, for example. In at least one embodiment, any or all of a cooling module 110 and/or any or all of a pumping module 130 can be disposed at least partially in the hot aisle 230, at an end of the row of cabinets 210, at least partially between a first row of cabinets 210 and a second row of cabinets 210 that is parallel to the first row of cabinets 210, or any combination thereof. In at least one embodiment, any or all of a cooling module 110 and/or any or all of a pumping module 130 can be disposed at least partially in the hot aisle 230, at an end of the row of cabinets 210, such as by removing or replacing one or more of the cabinets 210, or a portion of the cabinets 210, from one or more of the rows of cabinets.

In at least one embodiment, the cooling system 100 can include one or more cooling modules 110 arranged for free-cooling only, and one or more Direct Expansion (DX) related components can be absent (e.g., compressors, condenser heat exchangers, etc.). In at least one embodiment, the cooling system 100 can include water/glycol piping between the cooling module(s) 110, the pumping module 130, the cabinets 210, or any combination thereof. In at least one embodiment, the cooling system 100 can include one or more Direct Expansion (DX) circuits 122 that can be pre-charged at the factory.

In at least one embodiment, any or all of the cooling modules 110 can include a free cooling loop or circuit 120 and/or a Direct Expansion (DX) cooling loop or circuit 122, any or all of which can be plumbed in parallel or in series. In at least one embodiment, the fluid-to-air heat exchanger 114 can be or include one or more free-cooling heat exchangers 124, which can be plumbed in fluid communication with the pumping module 130. In at least one embodiment, the fluid-to-air heat exchanger 114 can be or include one or more condensers 118. In at least one embodiment, the fluid-to-air heat exchanger 114 can include a free-cooling heat exchanger 124 disposed adjacent to a condenser 118. In at least one embodiment, the fluid-to-air heat exchanger 114 can include a first free-cooling heat exchanger 124 disposed adjacent to a first condenser 118 and a second free-cooling heat exchanger 124 disposed adjacent to a second condenser 118. In at least one embodiment, the DX cooling circuit 122 can include one or more compressors 126. In at least one embodiment, the cooling module 110 can provide free cooling, such as using the fluid flowing through the free-cooling heat exchanger 124, and/or DX cooling, such as using the fluid flowing through the compressor 126 and the condenser 118. In at least one embodiment, the compressor 126 and/or the condenser 118 can be disposed within the cooling module 110. In at least one embodiment, one or more fans 112 can induce air flow from the cold aisle 220, then through the heat exchanger 114, then through the condenser 118, and then to the hot aisle 230 and/or containment plenum 240.

In at least one embodiment, the pumping module 130 can circulate the fluid through one or more heat sources 200 in one or more cabinets 210 and then through the fluid-to-air heat exchanger 114, such as the free-cooling heat exchanger 124 and/or the condenser 118, and then through the fluid-to-fluid heat exchanger 116. In at least one embodiment, any or all of the fluid can bypass the fluid-to-air heat exchanger 114 and flow through the fluid-to-fluid heat exchanger 116 of the cooling module 110. In at least one embodiment, the compressor 126 can be active when free cooling is insufficient to meet the cooling demand of the heat sources 200 in the cabinets 210. For example, with the compressor 126 active, heat can be transferred from the fluid to a refrigerant by the fluid-to-fluid heat exchanger 116, which can be a brazed plate heat exchanger (BPHE). In at least one embodiment, the compressor 126 can circulate the refrigerant through the DX circuit 122, such as the fluid-to-fluid heat exchanger 116 and/or the condenser 118, to extract heat from the fluid and the heat sources 200 in the cabinets 210.

In at least one embodiment, the free-cooling heat exchanger 124 can remain active any time the return fluid temperature is above one or more inlet air temperatures. In at least one embodiment, the cooling system 100 can control to the supply water temperature, can control the cooling capacity, or any combination thereof. In at least one embodiment, the cooling system 100 can include one or more sensors, such as temperature sensors, flow sensors, pressure sensors and/or other sensors, and one or more controllers for controlling one or more system components and/or processes. In at least one embodiment, the cooling system 100 can monitor one or more water temperatures, such as supply water temperatures, can control one or more water temperatures, such as a leaving water temperature, can modulate compressor capacity, can modulate one or more fan speeds, such as a condenser fan speed, or any combination thereof. In at least one embodiment, the cooling system 100 can include one or more receivers and one or more head-pressure-control-valves for controlling head pressure. In at least one embodiment, one or more head-pressure-control-valves can be arranged for bypassing around a condenser and backing refrigerant up into the condenser. In at least one embodiment, by reducing the condensing surface area, one or more fans can be operated, e.g., at 100%, during low inlet air temperatures while maximizing free cooling.

In at least one embodiment, the cooling module 110 can have an air flow path from an air inlet to an air outlet. In at least one embodiment, the free-cooling heat exchanger 124 and/or the condenser 118 can be disposed in the air flow path. In at least one embodiment, the condenser 118 can be disposed downstream of the free-cooling heat exchanger 124. In at least one embodiment, the fan 112 can induce air flow from the cold aisle 220 or the hot aisle 230, then through the free-cooling heat exchanger 124, then through the condenser 118, and then to the hot aisle 230 or the containment plenum 240. In at least one embodiment, the fan 112 can induce air flow from the cold aisle 220, then through the free-cooling heat exchanger 124, then through the condenser 118, and then to the hot aisle 230 and/or the containment plenum 240. In at least one embodiment, the fan 112 can induce air flow from the hot aisle 230, then through the free-cooling heat exchanger 124, then through the condenser 118, and then to the containment plenum 240.

In at least one embodiment, the cooling module 110 can have a cooling module housing 128. In at least one embodiment, the free-cooling heat exchanger 124, the condenser 118, the compressor 126, or any combination thereof can be disposed within the cooling module housing 128. In at least one embodiment, the fan 112 can be disposed downstream of the condenser 118 and/or route exhaust air upwardly and out of a top of the cooling module housing 128. In at least one embodiment, the fan 112 and/or the fluid-to-fluid heat exchanger 116 can be disposed within the cooling module housing 128. In at least one embodiment, the fluid-to-fluid heat exchanger 116 can have a DX flow path in fluid communication with the DX cooling circuit 112 and/or a free-cooling flow path in fluid communication with the free-cooling heat exchanger 124. In at least one embodiment, the free-cooling flow path of the fluid-to-fluid heat exchanger 116 can be fluidically downstream of the free-cooling heat exchanger 124.

In at least one embodiment, the cooling module 110 and/or the pumping module 130 can retrofit an existing data center. In at least one embodiment, the cooling module 110 and/or the pumping module 120 can be installed in place of one or more of the cabinets 210 in the row of cabinets. In at least one embodiment, the cooling module 110 and/or the pumping module 130 can at least partially convert one or more of the cabinets 210 in the row of cabinets from air-cooled to liquid-cooled with minimal changes to existing infrastructure. In at least one embodiment, the cooling module 110 and/or the pumping module130 can replace one or more of the cabinets 210 without requiring changes to containment plenum 240 above the hot aisle 230. In at least one embodiment, the cooling system 100 can be a modular, self-contained, free-cooling, in-row chiller capable of being headered together in parallel to meet a required or desired capacity.

In at least one embodiment, the pumping module 130 can be disposed between the cooling module 110 and the cabinets 210. In at least one embodiment, the pumping module 130 can control to a differential pressure between an inlet of the cooling module 110 and an outlet of the pumping module 130. In at least one embodiment, the controller 140 can control the cooling module 110 and/or the pumping module 130 according to a temperature of the fluid entering and/or exiting the pumping module 130, a temperature of the fluid entering and/or exiting the cooling module 110, a temperature of the fluid entering and/or exiting one or more of the cabinets 210, a differential pressure across the pumping module 130, a differential pressure across cooling module 110, a differential pressure across one or more of the cabinets 210, a flow rate through the pumping module 130, a flow rate through cooling module 110, a flow rate through one or more of the cabinets 210, or any combination thereof.

In at least one embodiment, a method according to the disclosure can be used for retrofitting a data center having heat sources 200 disposed in a row of cabinets 210 with a cold aisle 220 on one side of the row of cabinets 210, a hot aisle 230 on another side of the row of cabinets 210, and a containment plenum 240 above the hot aisle 230. In at least one embodiment, the method can include aligning at least one cooling module 110 with the cabinets 210 in the row, aligning a pumping module 130 with the cabinets 210 in the row, converting the row of cabinets 210 from air-cooled cabinets to liquid-cooled cabinets, or any combination thereof. In at least one embodiment, any or all of the cooling modules 110 can transfer heat from a fluid to air passing through the cooling module 110 and/or can include one or more fans 112 and one or more fluid-to-air heat exchanger 114. In at least one embodiment, the pumping module 130 can induce flow of the fluid between the cooling module 110 and the heat sources 200 and/or can include one or more pumps 132.

In at least one embodiment, a system according to the disclosure, such as a cooling system, can extract heat from one or more heat sources disposed in one or more rows of cabinets with a cold aisle on one side of the row of cabinets, a hot aisle on another side of the row of cabinets, and a containment plenum above the hot aisle. In at least one embodiment, the cooling system can include one or more cooling modules for transferring heat from a fluid to air passing through the cooling module, a pumping module for inducing flow of the fluid between the cooling module and the heat sources, a controller for controlling the cooling module and/or the pumping module, such as based at least in part on a differential pressure and/or a temperature of the fluid, or any combination thereof. In at least one embodiment, the pumping module can include one or more pumps. In at least one embodiment, the cooling module and/or the pumping module can be aligned with the cabinets in the row of cabinets. In at least one embodiment, the cooling module and/or the pumping module can be disposed at least partially in the hot aisle.

In at least one embodiment, the cooling module can be or include an in-row chiller for rejecting heat to the hot aisle. In at least one embodiment, the cooling module can receive air from the cold aisle and exhaust air to the hot aisle. In at least one embodiment, the cooling module can route or exhaust air to the hot aisle and/or the containment plenum. In at least one embodiment, the cooling module can include one or more fans and one or more fluid-to-air heat exchangers. In at least one embodiment, the cooling module can include one or more condensers. In at least one embodiment, the fan can move air from the cold aisle through the fluid-to-air heat exchanger and into the hot aisle. In at least one embodiment, the system can include a plurality of fans, such as a first fan disposed above a second fan. In at least one embodiment, the fluid-to-air heat exchanger can include a face, which can be disposed vertically.

In at least one embodiment, the cooling module can be serviced from a front side of the cooling module and a rear side of the cooling module. In at least one embodiment, the cooling module can be serviced from the front side and the rear side while the cooling module is disposed at least partially in the hot aisle. In at least one embodiment, the front side can face one of the hot aisle and the cold aisle, and the rear side can face the other one of the hot aisle and the cold aisle. In at least one embodiment, the cooling module can be selectively coupled to and uncoupled from one or more fluid manifolds that can route the fluid among the cooling module(s), the pumping module, the cabinets in the row of cabinets, or any combination thereof.

In at least one embodiment, a first cooling module and a second cooling module can each have a front side for facing the cold aisle and a rear side for facing the hot aisle. In at least one embodiment, the first cooling module and the second cooling module can be disposed across from one another with at least a portion of the hot aisle disposed between the rear side of the first cooling module and the rear side of the second cooling module.

In at least one embodiment, the cooling module and/or the pumping module can be disposed across the hot aisle and/or can straddle the hot aisle. In at least one embodiment, the cooling module and/or the pumping module can be disposed at least partially in the hot aisle, at an end of the row of cabinets, at least partially between a first row of cabinets and a second row of cabinets that is parallel to the first row of cabinets, or any combination thereof. In at least one embodiment, the system can include a plurality of cooling modules, which can be plumbed in parallel, can be interchangeable, can be disposed side-by-side, can be disposed across the cold aisle from one another and/or can be disposed across the hot aisle from one another, or any combination thereof. In at least one embodiment, the pumping module can be disposed side-by-side with one or more of the cooling modules. In at least one embodiment, the pumping module can be disposed between the cooling module and the cabinets.

In at least one embodiment, any or all of the cooling modules can include a free cooling loop or circuit and/or a Direct Expansion (DX) cooling loop or circuit, any or all of which can be plumbed in parallel or series. In at least one embodiment, the fluid-to-air heat exchanger can be or include a free-cooling heat exchanger, which can be plumbed in fluid communication with the pumping module. In at least one embodiment, the fluid-to-air heat exchanger can be or include a condenser. In at least one embodiment, the DX cooling circuit can include a compressor. In at least one embodiment, the fluid-to-air heat exchanger can include a first free-cooling heat exchanger disposed adjacent to a first condenser and a second free-cooling heat exchanger disposed adjacent to a second condenser. In at least one embodiment, the cooling module can have an air flow path from an air inlet to an air outlet. In at least one embodiment, the free-cooling heat exchanger and/or the condenser can be disposed in the air flow path. In at least one embodiment, the condenser can be disposed downstream of the free-cooling heat exchanger.

In at least one embodiment, the cooling module can have a cooling module housing. In at least one embodiment, the free-cooling heat exchanger, the condenser, the compressor, or any combination thereof can be disposed within the cooling module housing. In at least one embodiment, the fan can be disposed downstream of the condenser and/or route exhaust air upwardly and out of a top of the cooling module housing. In at least one embodiment, the cooling module can include a fluid-to-fluid heat exchanger disposed within the cooling module housing. In at least one embodiment, the fluid-to-fluid heat exchanger can have a DX flow path in fluid communication with the DX cooling circuit and a free-cooling flow path in fluid communication with the free-cooling heat exchanger. In at least one embodiment, the free-cooling flow path of the fluid-to-fluid heat exchanger can be fluidically downstream of the free-cooling heat exchanger.

In at least one embodiment, the cooling module and/or the pumping module can retrofit an existing data center. In at least one embodiment, the cooling module and/or the pumping module can be installed in place of one or more of the cabinets in the row of cabinets. In at least one embodiment, the cooling module and/or the pumping module can at least partially convert one or more of the cabinets in the row of cabinets from air-cooled to liquid-cooled. In at least one embodiment, the cooling module can have a cooling module depth and at least one of the cabinets can have a cabinet depth. In at least one embodiment, the cooling module depth can be less than or equal to the cabinet depth.

In at least one embodiment, a method according to the disclosure can be used for retrofitting a data center having heat sources disposed in a row of cabinets with a cold aisle on one side of the row of cabinets, a hot aisle on another side of the row of cabinets, and a containment plenum above the hot aisle. In at least one embodiment, the method can include aligning at least one cooling module with the cabinets in the row, aligning a pumping module with the cabinets in the row, converting the row of cabinets from air-cooled cabinets to liquid-cooled cabinets, or any combination thereof. In at least one embodiment, any or all of the cooling modules can transfer heat from a fluid to air passing through the cooling module and/or can include one or more fans and one or more fluid-to-air heat exchanger. In at least one embodiment, the pumping module can induce flow of the fluid between the cooling module and the heat sources and/or can include one or more pumps.

Other and further embodiments utilizing one or more aspects of the disclosure can be devised without departing from the Applicant's disclosure. For example, the devices, systems and methods can be implemented for numerous different types and sizes in numerous different industries. Further, the various methods and embodiments of the devices, systems and methods can be included in combination with each other to produce variations of the disclosed methods and embodiments. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The disclosures have been described in the context of preferred and other embodiments and not every embodiment of the disclosures have been described. Obvious modifications and alterations to the described embodiments are available to those of ordinary skill in the art having the benefits of the present disclosure. The disclosed and undisclosed embodiments are not intended to limit or restrict the scope or applicability of the disclosures conceived of by the Applicant, but rather, in conformity with the patent laws, the Applicant intends to fully protect all such modifications and improvements that come within the scope of the following claims.

## Claims

1. A cooling system (100) for heat sources (200) disposed in a first row of cabinets (210) with a cold aisle (220) on one side of the first row of cabinets, a hot aisle (230) on another side of the first row of cabinets, and a containment plenum (240) above the hot aisle, the cooling system comprising:
at least one cooling module (110) comprising at least one fan (112) and at least one fluid-to-air heat exchanger (114), the at least one cooling module being configured to transfer heat from a fluid to air passing through the at least one cooling module; and
a pumping module (140) comprising at least one pump (132) and configured to induce flow of the fluid between the at least one cooling module and the heat sources,
wherein the at least one cooling module and the pumping module are configured to be disposed at least partially in the hot aisle.

2. The cooling system as set forth in claim 1, wherein the at least one cooling module is configured to be disposed across the hot aisle.

3. The cooling system as set forth in claim 1 or 2, wherein the at least one cooling module is configured to straddle the hot aisle.

4. The cooling system as set forth in any preceding claim, wherein the at least one cooling module is configured to be disposed at least partially in the hot aisle and at least partially between the first row of cabinets and a second row of cabinets that is parallel to the first row of cabinets.

5. The cooling system as set forth in any preceding claim, wherein the pumping module is configured to be disposed at least partially in the hot aisle and at least partially between the first row of cabinets and a second row of cabinets that is parallel to the first row of cabinets, and/or wherein the at least one cooling module is configured to be disposed at least partially in the hot aisle and at an end of the first row of cabinets.

6. The cooling system as set forth in any preceding claim, wherein the at least one cooling module comprises a plurality of cooling modules configured to be disposed side-by-side.

7. The cooling system as set forth in claim 6, wherein each of the plurality of cooling modules comprises a free cooling loop, and wherein the free cooling loops are configured to be plumbed in parallel, and/or wherein the pumping module is configured to be disposed side-by-side with one or more of the plurality of cooling modules.

8. The cooling system as set forth in any preceding claim, wherein the at least one cooling module is configured to exhaust air towards the containment plenum, and/or wherein the at least one cooling module is configured to be serviced from a front side of the at least one cooling module and a rear side of the at least one cooling module while the at least one cooling module is disposed at least partially in the hot aisle.

9. The cooling system as set forth in any preceding claim, further comprising at least one controller configured to control the at least one cooling module and the pumping module based at least in part on a temperature of the fluid.

10. The cooling system as set forth in any preceding claim, wherein the at least one fluid-to-air heat exchanger comprises a free-cooling heat exchanger configured to be plumbed in fluid communication with the pumping module.

11. The cooling system as set forth in claim 10, wherein the at least one fluid-to-air heat exchanger further comprises a condenser, and wherein the at least one cooling module further comprises a direct expansion (DX) cooling circuit.

12. The cooling system as set forth in claim 11, wherein the at least one cooling module has an air flow path from an air inlet to an air outlet, wherein the free-cooling heat exchanger and the condenser are disposed in the air flow path, and wherein the condenser is disposed downstream of the free-cooling heat exchanger, and/or wherein the at least one fan is disposed downstream of the condenser and is configured to route exhaust air upwardly and out of a top of the cooling module housing.

13. The cooling system as set forth in claim 11, wherein the at least one cooling module has a cooling module housing, wherein the DX cooling circuit comprises a compressor, and wherein the free-cooling heat exchanger, the condenser and the compressor are disposed within the cooling module housing.

14. The cooling system as set forth in claim 13, wherein the at least one cooling module further comprises a fluid-to-fluid heat exchanger disposed within the cooling module housing, and wherein the fluid-to-fluid heat exchanger has a DX flow path in fluid communication with the DX cooling circuit and a free-cooling flow path in fluid communication with the free-cooling heat exchanger, and optionally, wherein the free-cooling flow path of the fluid-to-fluid heat exchanger is fluidically downstream of the free-cooling heat exchanger.

15. The cooling system as set forth in any preceding claim, wherein the at least one fluid-to-air heat exchanger comprises a first free-cooling heat exchanger disposed adjacent to a first condenser, and a second free-cooling heat exchanger disposed adjacent to a second condenser.
